(19) Europäisches Patentamt
European Patent Office
Office européen des brevets

(11) **EP 4 120 565 B1**

(12) **EUROPEAN PATENT SPECIFICATION**

(45) Date of publication and mention
of the grant of the patent:
**25.03.2026 Bulletin 2026/13**

(21) Application number: **21185740.4**

(22) Date of filing: **15.07.2021**

(51) International Patent Classification (IPC):
***H03H 19/00*** *(2006.01)*

(52) Cooperative Patent Classification (CPC):
**H03H 19/004**

(54) **METHOD OF FILTERING A SIGNAL USING AN ANALOG CIRCUIT AND CORRESPONDING FILTERING CIRCUIT**

VERFAHREN ZUR FILTERUNG EINES SIGNALS UNTER VERWENDUNG EINER ANALOGEN SCHALTUNG UND ENTSPRECHENDE FILTERSCHALTUNG

PROCÉDÉ DE FILTRAGE D'UN SIGNAL À L'AIDE D'UN CIRCUIT ANALOGIQUE ET CIRCUIT DE FILTRAGE CORRESPONDANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**18.01.2023 Bulletin 2023/03**

(73) Proprietor: **Fraunhofer-Gesellschaft zur Förderung
der angewandten Forschung e.V.
80686 München (DE)**

(72) Inventor: **Herzer, Elmar
91058 Erlangen (DE)**

(74) Representative: **Gagel, Roland
Patentanwalt Dr. Roland Gagel
Landsberger Strasse 480a
81241 München (DE)**

(56) References cited:
**WO-A1-2012/014464      US-A1- 2013 120 033**

• **REPO H ET AL: "Programmable switched capacitor 4-tap fir filter", EUROPEAN SOLID-STATE CIRCUITS, 2003. ESSCIRC '03. CONFERENCE ON 16-18 SEPT. 2003, IEEE, PISCATAWAY, NJ, USA, 16 September 2003 (2003-09-16), pages 445 - 448, XP010677425, ISBN: 978-0-7803-7995-4, DOI: 10.1109/ ESSCIRC.2003.1257168**

## Description

### Technical Area

The present invention relates to a method of filtering a signal, in particular a Gauss-type or a Gabor-type filtering, using an analog circuit. Invention also relates to a filtering circuit for executing the proposed method.
Signals from sensors are often overlaid by noise or base line variations that need to be removed before the signal can be analyzed. This is the case for example with heart beats in ECG signals where muscle activity and 50Hz power coupling disturb the actual ECG signal.
In a more general sense, raw signals from sensors often require filtering to remove or focus on certain frequency components. Digital filtering has disadvantages if both the incoming signal is provided and the filtered signal is required in analog form. Furthermore, Gaussian filters are very difficult to implement in digital filters. Analog filtering on the other hand often requires large resistors and/or large capacitors and thus a lot of chip area in order to create large RC time constants for the filtering of very slow signals.

### Prior Art

WO2012/014464 A1 describes a discrete time analog circuit. WO 2012/129296 A1 describes an analog finite impulse response (FIR) filter for signal processing. The filter produces a differential output having a desired frequency response and capable of having negative coefficients. The filter uses a chain of unit delay elements. Each tap of the chain is buffered and the outputs of the buffers are summed up by a resistive network. The circuit can realize FIR filters designed after the McClellan filter design algorithm. With the trick of summing up inverted or non-inverted outputs there can be positive or negative values of the impulse response. By alternating the coefficients and summing up with equal resistors, the circuit is able to calculate Fourier coefficients to characterize the frequency content of the input signal.
A dynamically reconfigurable signal processing circuit, pattern recognition apparatus, and image processing apparatus is described in EP 1246121 B1. The signal processing circuit is based on a spatial arrangement of active blocks and switch blocks for filtering an image with a Gabor-type filter kernel. A spatial filter circuit element of this filter circuit comprises a network of transconductance amplifiers, capacitors and resistors.
A similar filter element is shown in B.E. Shi, "Gabor-type filtering in space and time with cellular neural networks", IEEE Transactions on Circuits and Systems I: Fundamental Theory and Application, Vol. 45, No. 2, 1998, pages 121 to 132. This publication also shows a 1-D low pass filtering network to realize low-pass spatial filtering. The network consists of resistors, capacitors and current sources which inject currents proportional to the input signals. The outputs are represented by the voltages. With such a circuit an approximate Gaussian filtering is achieved.
It is an object of the present invention to provide a method of filtering a signal using an analog circuit and a corresponding analog filtering circuit, the method and the filtering circuit allowing a Gaussian filtering with a filter bandwidth which is easy to adjust.

### Summary of the invention

The object is achieved with the method and filtering circuit according to claims 1 and 11. Advantageous embodiments of the method and filtering circuit are subject matter of the dependent claims or are described in the subsequent portions of the description and exemplary embodiments.
In the proposed method in its basic form the signal to be filtered is sampled to obtain a series of signal values $SV0$ to $SVn$. Depending on the type of the signal, i.e. a timely signal or a spatial signal, the sampled signal values correspond to a time series or to a positional series of sampled values. The signal values $SV0$ to $SVn$ are then stored in form of charges in a series of first capacitors $C0$ to $Cn$, said series of first capacitors $C0$ to $Cn$ corresponding to said series of signal values $SV0$ to $SVn$. This means that value $SV0$ is stored in capacitor $C0$, value $SV1$ is stored in capacitor $C1$ and so on. The term "series" in this context represents a sequence and does not mean a series connection of electrical components. The filtering is then performed by diffusing the charges on each first capacitor over neighboring capacitors of said series of first capacitors by connecting a resistor for at least partial charge equalization between each pair of consecutive first capacitors $Ci$, $Ci+1$ ($i = 0$ to $n-1$) in said series of first capacitors for a first time interval which is selected dependent on the desired filtering result. This diffusion is made for all first capacitors of the series at the same time. This means that during said first time interval a common compensation line is formed to which all first capacitors of the series are connected and which has a resistor between every two connecting points of the first capacitors to the compensation line. This connection for the first time interval may be achieved using appropriate switches. The remaining voltages across the first capacitors of the series of first capacitors after said diffusion step represent the filtered signal values corresponding to a filtered signal.
The filtering according to the present method is based on charge diffusion. The to be filtered signal is stored as charges on capacitors. Then the charge on each capacitor is diffused over neighboring capacitors by connecting resistors between the capacitors for a short time. The remaining voltages across the capacitors represent the filtering result. The filter characteristics approximately matches the characteristics of a convolution with a Gaussian filter kernel as will be illustrated based on the circuit theory of an RLC and RC transmission line in the following.

In a parameter description of a RLC transmission line (see Lieberstein, H. Melvin. Mathematics in Science and Engineering: Theory of Partial Differential Equations. Elsevier, 1972, chapter 8) the differential formulation for currents and voltages may be given by

$$\frac{\partial i}{\partial x} = gv + c\frac{\partial v}{\partial t}$$

$$\frac{\partial v}{\partial x} = ri + l\frac{\partial i}{\partial t},$$

where i is the current along the resistance per length r and the inductance per length l; v is the voltage across the capacitance per length c and the leakage transconductance per length g. There is also the time t and the location along the line x.

This is solved to

$$\frac{\partial^2 v}{\partial x^2} - lc\frac{\partial^2 u}{\partial t^2} = (rc + lg)\frac{\partial v}{\partial t} + rgv$$

Discarding the inductance for a lossy RC line, it yields

$$\frac{\partial^2 v}{\partial x^2} = rc\frac{\partial v}{\partial t} + rgv$$

and

$$v(x,t) = C_0\, e^{-(g/c)\,t}\sqrt{\frac{rc}{\pi t}}\, e^{-\frac{rc}{4t}x^2}$$

Without loss (or leakage, g = 0), it simplifies to

$$v(x,t) = C_0\sqrt{\frac{rc}{\pi t}}\, e^{-\frac{rc}{4t}x^2}$$

Taking this at a certain time t for an initial charge at center, we end up with a voltage over location x-μ that corresponds the form of a Gaussian filter kernel:

$$v(x-\mu) = \frac{V_0}{\sqrt{2\pi\sigma^2}}\, e^{-\frac{(x-\mu)^2}{2\sigma^2}}$$

So in theory, a RC line could be seen as a Gaussian filter for a charge that is placed into the center position x = μ of a RC transmission line. The proposed method and filtering circuit are based on a discrete approximation of this RC-line behavior.

In the proposed method, the to be filtered timely signals are sampled over time and then the sampled values are processed in parallel using a different time constant. This is done by calculating convolutions with Gaussian kernels where the signal properties can be transformed into electrical features, which can then for example be analyzed by a neural network. The method also allows to filter spatial signals, i.e. signals from a one dimensional array of e.g. sensors or antennas. Each sampled value then corresponds to a spatial position in the corresponding array.

In an advantageous embodiment, the signal values SV0 to SVn are stored additionally in form of charges in a series of second capacitors Cb0 to Cbm, said series of second capacitors corresponding to said series of signal values SV0 to SVn. As already explained in connection with the basic form of the method, this means that value SV0 is stored in capacitor Cb0, value SV1 is stored in capacitor Sb1 and so on. In this embodiment, the remaining voltages across the first capacitors of the series of first capacitors after said diffusion step are subtracted from the voltages across the second capacitors of the series of second capacitors for each pair of first and corresponding second capacitors (corresponding to the same signal value) - or vice versa -, to obtain a difference between the filtered and unfiltered signal. When the filtered signal has been low-pass filtered by selecting the appropriate (first) time interval for diffusion, a high-pass filtered signal is obtained with the above subtraction.

In a further advantageous embodiment, the charges on each second capacitor of the previously described embodiment are also diffused over neighboring capacitors of said series of second capacitors by connecting a resistor for at least partial charge equalization between each pair of consecutive second capacitors in said series of second capacitors for a second time interval, which second time interval is selected dependent on a desired second filtering result. This diffusion step is performed for all second capacitors of the series at the same time. As in the previous embodiment, after said diffusion steps, the remaining voltages across the first capacitors of the series of first capacitors are subtracted from the remaining voltages across the second capacitors of the series of second capacitors for each pair of first and corresponding second capacitors (corresponding to the same signal value) - or vice versa -, to obtain a difference between the filtered signals. Depending on the selection of the time intervals and the direction of the subtraction, different filtering results are achieved, for example a band-pass filtering with upper and/or lower crossover frequency defined by the duration of one or both time intervals.

The diffusion steps may also be repeated one or several times with equal or different first and/or second time intervals before new signal values are stored in the capacitors. With such a repetition, several filtered signals with different filtering results can be achieved based on the same input signal.

The proposed method also allows a Gabor-type filtering of the signals. A Gabor filter is a complex exponential function modulated by a Gaussian

$$g(x) = \frac{1}{\sqrt{2\pi}\sigma} \, e^{-(x^2/2\sigma^2)} \, e^{j\omega_{xo}x}$$

$$= \frac{1}{\sqrt{2\pi}\sigma} \, e^{-(x^2/2\sigma^2)} \, (\cos(\omega_{xo}x) + j\sin(\omega_{xo}x))$$

(Equation 1)

In the proposed method, the real part and the imaginary part calculations of this filter are completely separated, each performed using the diffusion step of the proposed method, wherein the diffusion parameter $\sigma$ can be chosen in a wide range by the duration of the corresponding time interval for diffusion. The signal values are stored on the capacitors multiplied with a factor depending on the corresponding cosinus- or sinus-value of the real and imaginary part of the Gabor filter. In case of a period of the angular frequency $\omega_{x0}$ corresponding to four consecutive signal values, the above factor alternates between +1 and -1 and can be implemented for example by providing an additional input with the inverted signal. In case of a period of the angular frequency $\omega_{x0}$ larger than four input samples, a second capacitor is required for each sample value in order to achieve the corresponding partial storage of the signal value in one of the capacitors.

The proposed filtering circuit comprises in its basic form a series of first capacitors C0 to Cn connected to one or several input lines via sampling switches, such that a signal can be sampled using the sampling switches to obtain a series of signal values SVO to SVn, which are stored in form of charges in the corresponding first capacitors C0 to Cn. Each capacitor is connected to an output terminal allowing to tap the voltage across the capacitor at the output terminal. Between each two adjacent first capacitors there is a series connection of a resistor and a switch connected for opening and closing the connection between these capacitors.

The proposed method and corresponding filtering circuit allow a Gaussian filtering of analog signals using an analog circuit in which the width of the Gaussian filter can be easily varied or adapted by varying the time interval for diffusion. In comparison with traditional approaches which take a lot of energy, the proposed method and filtering circuit require less energy for filtering, even lesser than what is needed for storing the signal. This is very advantageous in cases where there is an analog storage (e.g. in a track and hold circuit) of the signals needed for other reasons in the system. There is even more power efficiency when the corresponding buffers are powered down while the inputs are sampled to the capacitors (low frequency) and while/after filtering the buffers are powered up for a short period where the results are processed in the circuit that follows this filtering circuit (much faster processing than sampling). The most versatile variant of this invention can be used to do successive filtering over a wide range of frequency bands. Taking two of the proposed basic filtering circuits in parallel for real and imaginary parts, a Gabor-type filtering can be performed which is often used for feature extraction in frontends of neural networks. The oscillation period $\omega_{x0}$ for the Gabor-type filtering would be set fixed by the circuit implementation.

In addition, the proposed method and corresponding filtering circuit can be used as convolution filter in analog deep neural networks. Currently, filter layers in neural networks are defined by their individual impulse response values which are set freely in a particular range. These values are called weight factors in neural network design. These can be realized with one of the filtering circuits according to the present invention. Then the weight factors of all kernels are limited to be always from Gaussian distribution but the width parameter $\sigma$ of the Gaussian curve represents the learned parameter for the variation of the filtering.

The proposed method and filtering circuit are a simple solution to provide a Gaussian filtering of a signal. The transfer function of a Gaussian filter is not rational and therefore does not have any finite pole. Therefore, it is not possible to implement a Gaussian filter in switched capacitor or active-RC circuit technologies that implement rational transfer functions.

The proposed method and filtering circuit can be used in many technical fields including the processing of audio-, ultrasound- and radar-signals, in the processing of sensor signals for industry and medical technology, for removing of disturbances and superposed DC signals. Furthermore, the method and filtering circuit are usable for flexible spectral analysis, low-pass filtering, high-pass filtering and/or bandpass filtering of signals and for driving the inputs of an analog neuronal network. This applies in particular for mixed-signal AI-ASICs which require a filtering front end.

## Short description of the drawings

The proposed method and filtering circuit are further described in the following by way of examples in connection with the accompanying figures. The figures show:

Fig. 1 an array of sample and hold circuits for sampling a timely signal into a vector of parallel signals according to the prior art;

Fig. 2 a representation of the sampling of the signals with the circuit of Figure 1;

Fig. 3 a first example of the proposed filtering circuit;

Fig. 4 an example of a to be filtered signal and the filtering results with a filtering circuit according to figures 3 and 5;

Fig. 5 a second example of the proposed filtering circuit;

Fig. 6 a third example of the proposed filtering circuit;

Fig. 7 a fourth example of the proposed filtering circuit; and

Fig. 8 an example of a basic cell of a sixth example of the proposed filtering circuit.

## Detailed description of embodiments

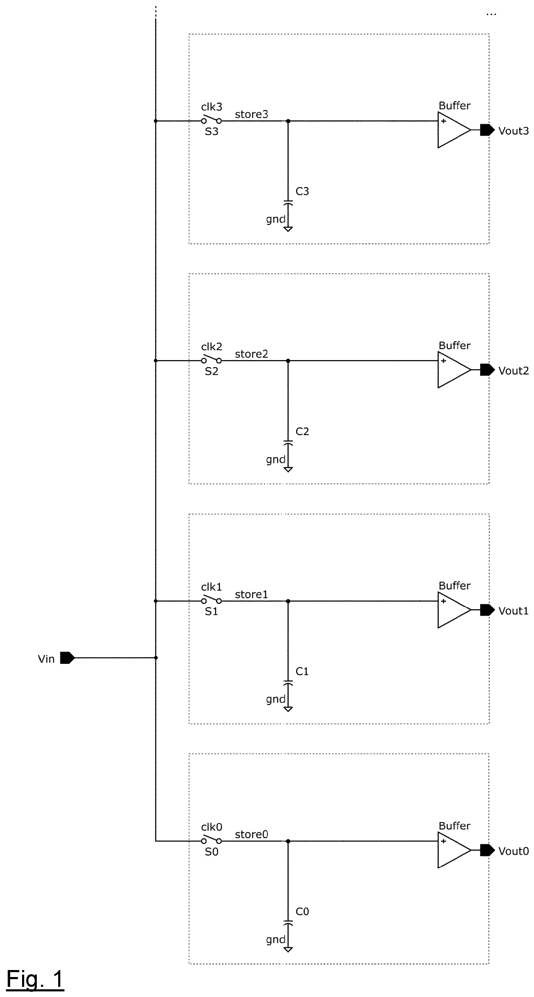

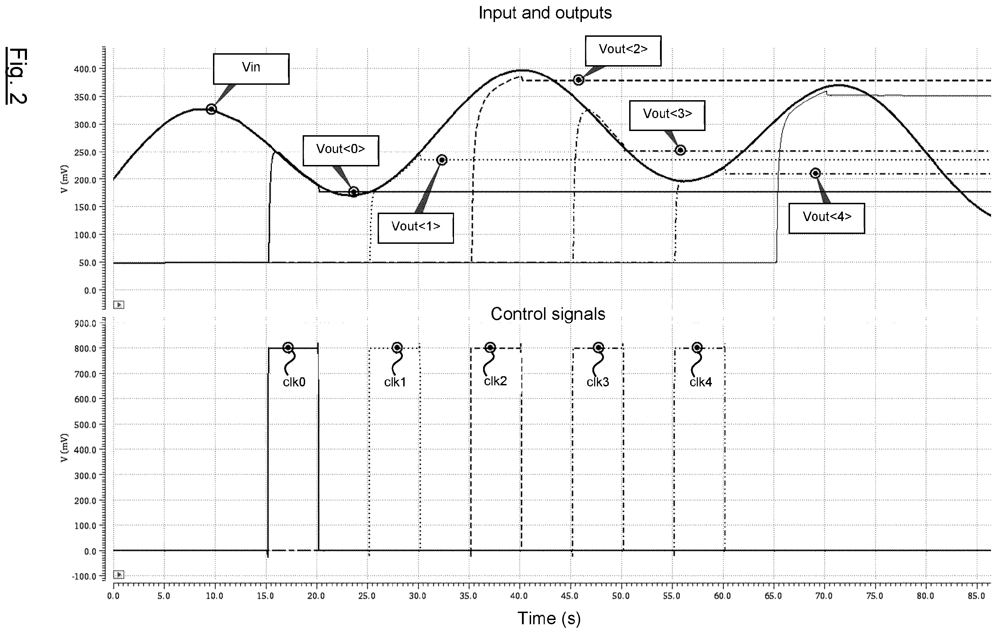

It is well known that a time series of voltages on an input net Vin can be converted into a bundle of parallel output signals $Vout_0$ ... $Vout_N$ by an array of sample and hold circuits. Figure 1 shows an example of such a circuit which consists of a switch $S_N$ manipulated by a clock signal $clk_N$. Each signal is stored on a capacitor $C_N$ and the buffer amplifier between the capacitor and the output terminal ensures that the stored voltage does not change very much in case of a change of load at the $Vout_N$ output terminals. Figure 2 shows an example of the signal input to and the signal values output from the circuit of Figure 1. In the upper part of this figure the continuous input signal Vin is shown together with the sampled values $Vout_N$ based on the clock signals $clk_N$ indicated in the lower part of the figure.

The method and filtering circuit according to the present invention also use such a sampling in case of the filtering of a timely signal. In case of a spatial signal, multiple input lines, one for each capacitor, are used. The sampling on each input line is then performed for all capacitors at the same time. Such a spatial signal can for example be received from an array of sensors or antennas. Then there would be no common Vin, but each of the sampling switches $S_N$ would be connected to a separate input.

In the proposed method, after storing of the signal samples on the capacitors, the capacitors are connected together by means of switched resistors for a short time, i.e. for a particular short time interval. Consequently, the charge on these capacitors distributes via the resistors across neighboring capacitors. Large differences between adjacent capacitors will compensate quickly, whereas changes between capacitors that are far from each other would need a longer time to compensate in the same amount. The time interval for connecting the capacitors together is selected in dependence on the desired filtering result.

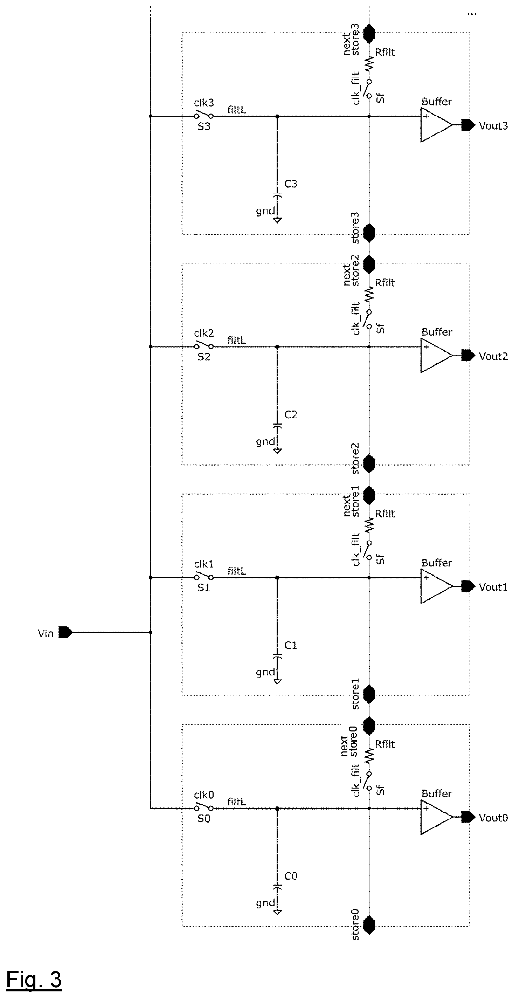

Figure 3 shows the corresponding circuit according to the present invention. It corresponds to the sampling circuit of Figure 1 plus resistors $R_{filt}$ and switches Sf between adjacent capacitors. Upon closing these switches Sf, the charge in the capacitors will distribute via these switches and resistors. Because of the presence of the resistors $R_{filt}$, in the following also called filtering resistors, the current i between any two capacitors in the chain is directly related to their voltage difference and inversely related to the number of filtering resistors $R_{filt}$ between them. The further away two capacitors are, more are the number of resistors.

$$i_{Rfilt}n = \frac{V(C_{n+1}) - V(C_n)}{R_{filt}}$$

This current i, on the other hand, changes the voltages across the capacitors, because the voltage across a capacitor is proportional to the charge stored on the capacitor, **i.e.** the current moves the charges from or to the capacitors.

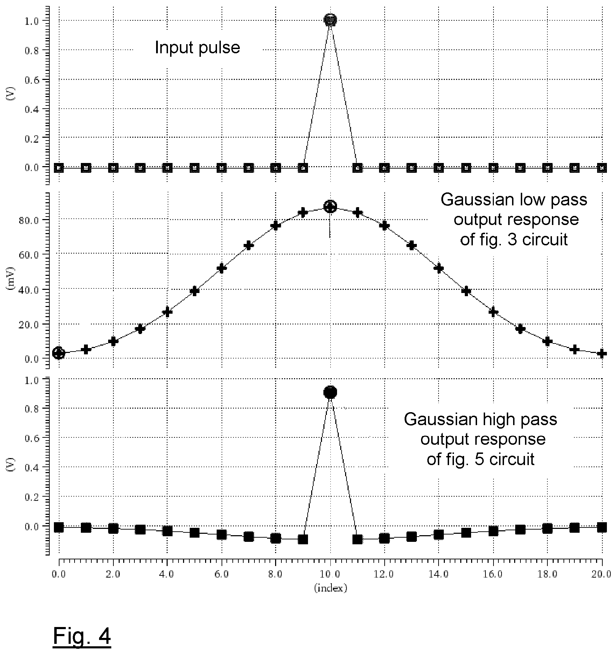

The basic function of the circuit of Figure 3 is explained in the example shown in Figure 4 in which the pulse response of the circuit is shown by charging one capacitor in the center of the series of capacitors to a certain voltage and charging **all** the rest to zero (see Figure 4 top). The individual points on the diagram on top of this figure show the voltages of the series of capacitors before charge distribution. Then the switches between the capacitors are closed for a short time for charge distribution. After opening the switches again the charge distribution stops and the voltages on the capacitors show the impulse response of the resulting low pass filter shown in the diagram in the center of Figure 4. This diagram illustrates the voltages of the different capacitors after the charge distribution for the selected time interval. Because this distribution of charges (while the switches are closed) is a diffusion process, the impulse response shows a Gaussian characteristic representing a low-pass filtering. The width of the filtered signal can be influenced by the time interval for which the switches are closed.

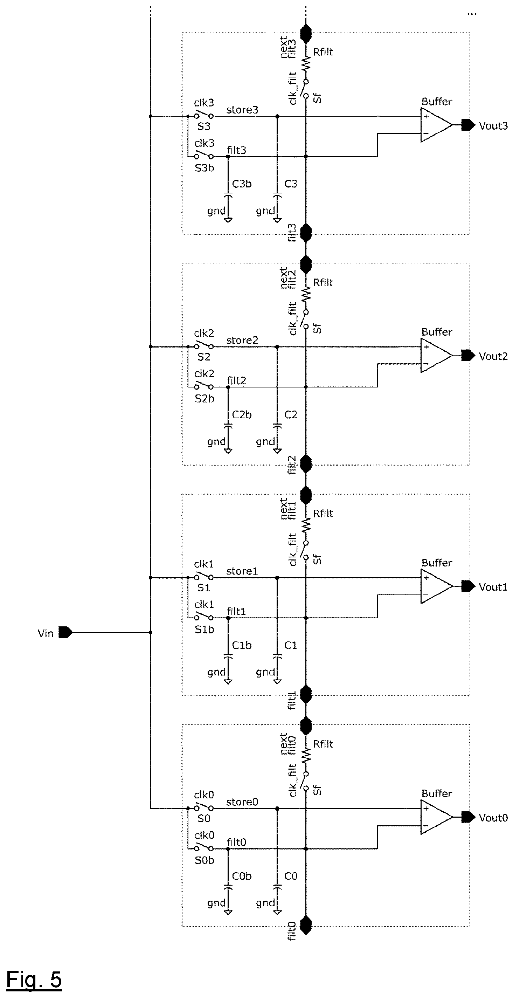

Figure 5 shows a further example of the proposed filtering circuit. With this exemplary circuit a high-pass filtering can be achieved. The circuit comprises a second sampling capacitor and a second sampling switch for each sampling stage or sampling value. The input is sampled on both capacitors $C_i$ and $C_ib$ simultaneously, while filtering is applied only to one of two capacitors per stage. The output buffer then outputs the difference between the unfiltered and filtered signals. The circuit of Figure 5 thus shows the impulse response illustrated at the bottom of Figure 4. This represents a high-pass filtering by subtraction of a low-pass filter signal from the input signal.

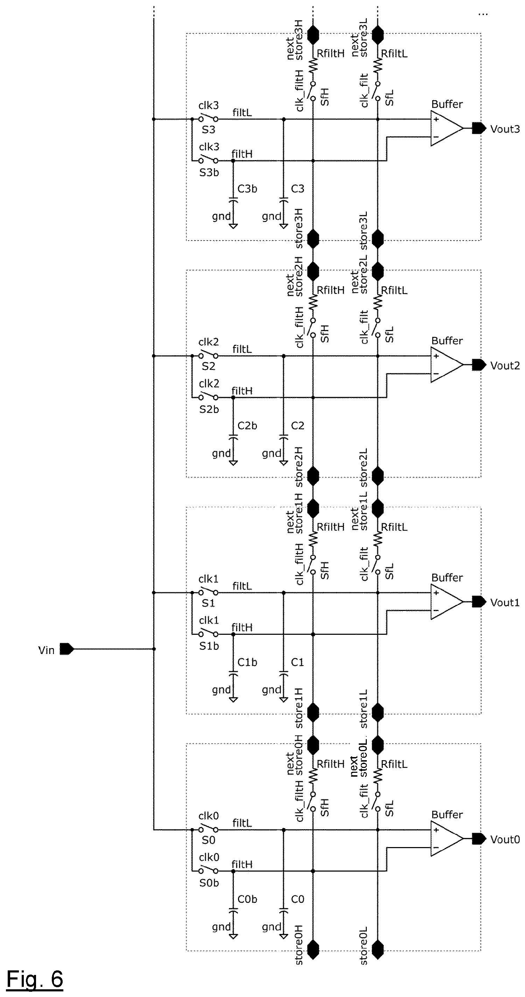

A further example of the proposed filtering circuit is shown in Figure 6. With such a filtering circuit a universal filtering by subtraction of two filtered signals from each other can be obtained. As in the case of Figure 5, each sampled value is stored on two capacitors $C_i$ and $C_ib$ at each stage. The two capacitors of all stages form two series of capacitors, the charges of which can be diffused in the same manner between the capacitors of the corresponding series. Depending on the duration of the corresponding charge distribution induced by the switch control signals $clk_{filtH}$ and $clk_{filtL}$ the filter characteristics of this circuit can be varied in a large range. In the following, several possibilities of operating the filtering circuit of Figure 6 are described:

1) Not activating clk_filtL, but only activating clk_filtH will yield a high-pass filter, like shown in Figure 5.
2) Activating clk_filtH for such a long time, that all the charges on Cxb can settle completely, they settle to the average input voltage and the output is the original input voltage minus the average DC value.
3) Not activating clk_filtH, but only activating clk_filtL will yield a high-pass filter. This is similar to what is shown in Figure 5 but with inverted output.
4) Activating clk_filtH for the same duration as clk_filtL should not output any signal in an ideal circuit, but it will reveal an offset of the output buffer when there is any.
5) Activating clk_filtH for a shorter time than clk_filtL will yield a bandpass filter with upper crossover frequency defined by the duration of clk_filtH and the lower crossover frequency defined by the duration of clk_filtL.
6) Activating clk_filtH for a longer time than clk_filtL will yield a bandpass filter with upper crossover frequency defined by the duration of clk_filtL and the lower crossover frequency defined by the duration of clk_filtH and with inverted output.

The proposed filtering circuit can also be used for spectral analysis as is explained in the following. Selecting for example the above options 5) or 6), it is possible to first close the filtering switches only for a short time and then capture the result. After this, the filtering can be repeated without resampling the inputs, even for multiple steps. Upper and lower crossover frequencies will move down in each step. With an adequate control of both clk_filtH and clk_filtL duration, the bandwidth and cross over frequencies of each step can be controlled separately. This successive filtering only needs the energy to control the switches and no additional energy is needed. This is very efficient. The captured output signals can then be fed into an amplitude detector to determine the signal energy per filtered frequency band. It is useful to capture less outputs, for example only the outputs of each second or fourth capacitor of each series, for lower frequencies i.e. down sampling.

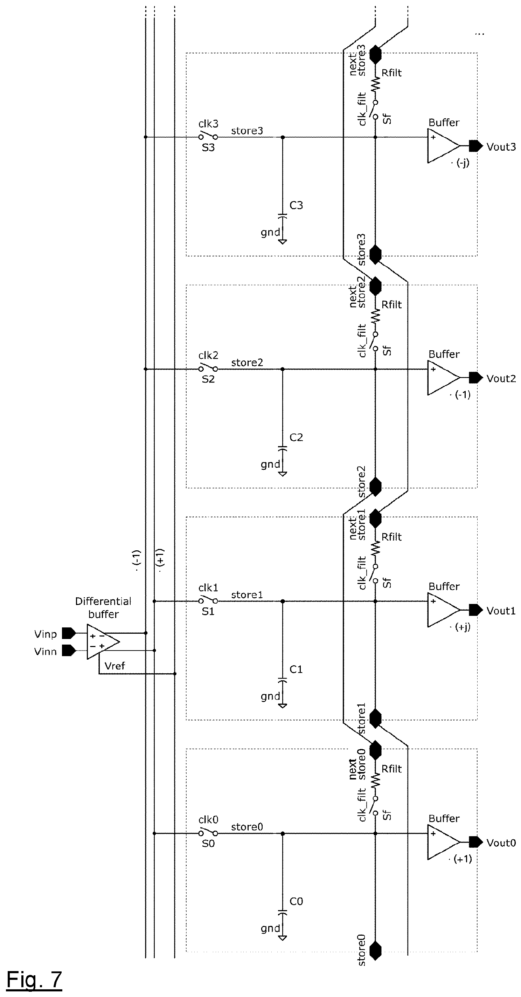

It is possible to provide a circuit like the one shown in Figure 3 that calculates the Gabor-type filtering from Equation **1**. While the diffusion parameter $\sigma$ can be chosen in a wide range by the duration of the filtering, the sine period $\omega_{x0}$ is implemented in the circuit in the embodiment of Figure 7 such that there are only the factors $\{1,j,-1,-j\}$. Figure 7 shows such a circuit. In this embodiment $\omega_{x0}$ is selected for a special period for the oscillatory factor of the filter of four input samples. This means that there are four types of contributions from the inputs to the outputs. Odd numbered inputs contribute to the real part shown at the odd numbered outputs and even numbered inputs contribute to the imaginary part shown at the even numbered outputs. Additionally, each second contributor needs to change its sign. In Figure 7 this is realized by adding a differential input buffer to provide an inverted and a non-inverted input signal on two input lines for sampling. In an alternative embodiment, this could also be realized by reversing the capacitors of one input signal after sampling, using additional switches per capacitor. There is no issue with a common mode signal, which is the same on both lines.

Since the real part and imaginary part calculations are completely separated, they can be calculated by an interlaced filtering scheme: The filtering switches and resistors are connected to the capacitors after the next capacitor (Figure 7). This yields two filtering connections on top and bottom instead of one, compared to the single filt and nxtfilt in the circuits shown in Figure 3 to Figure 6. Figure 7 shows the four filtering cells that build the core module of the filtering circuit of this embodiment. The complete core module needs to be repeated a lot of times for a good filtering result. The two input lines are shared between all modules while the two filtering connections from the top connect to the bottom of the next module.

Preferably, a further circuit is added to every two outputs to the circuit shown in Figure 7 to calculate one amplitude or signal energy measure from the real part and imaginary part components provided at $Vout_N$ and $Vout_{N+1}$.

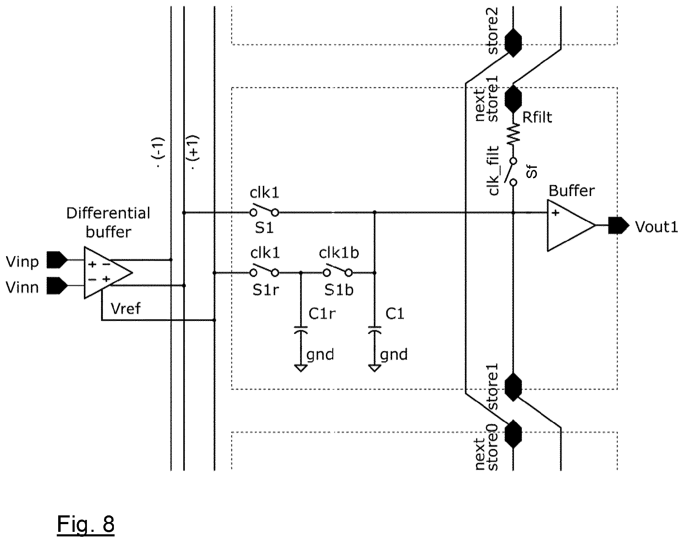

When $\omega_{x0}$ is selected for a larger period than four input samples, there are twice the number of capacitors required. The input capacitors are split into two parts to acquire only a part of the charge available from input voltage. Figure 8 shows the additional parts per filter cell:

- A switch $S_N r$ and a capacitor $C_N r$ to sample the reference voltage like the input voltage. The sum of $C_N + C_N r = C_{unit}$ corresponds to the value of all $C_N$ shown in Figure 7.
  To realize a factor of $0 < y < 1$, there should be $C_N = \gamma \cdot C_{unit}$ and $C_N r = (1-\gamma) \cdot C_{unit}$
- A switch $S_N b$ to short $C_N$ and $C_N r$ after the two sampling switches have been re-opened and a signal clk1b to steer this switch.

This makes it possible to realize the sine or the cosine factors of Equation 1.

To realize a filter with a period of 8, 16 such cells are needed. Their components are listed in the following table. It is possible to have an output buffer only on a few of the 16 cells (down sampling of filtered result).

| Index | Factor $\gamma$ | Sign | Decimal value of $\gamma$ | Comment | Charge distribution in / output to |
|---|---|---|---|---|---|
| 0 | Sin(0) | | 0 | No $C_0$ | Imaginary part |
| 1 | Cos(0) | +1 | 1 | No $C_1r$ | Real part |
| 2 | Sin($\pi/4$) | +1 | 0.707 | | Imaginary part |
| 3 | Cos ($\pi/4$) | +1 | 0.707 | | Real part |
| 4 | Sin($2\,\pi/4$) | +1 | 1 | No $C_4r$ | Imaginary part |
| 5 | Cos($2\,\pi/4$) | | 0 | No $C_5$ | Real part |
| 6 | Sin($3\,\pi/4$) | +1 | 0.707 | | Imaginary part |
| 7 | Cos($3\,\pi/4$) | -1 | 0.707 | | Real part |
| 8 | Sin($\pi$) | | 0 | No $C_8$ | Imaginary part |
| 9 | Cos($\pi$) | -1 | 1 | No $C_9r$ | Real part |
| 10 | Sin($5\pi/4$) | -1 | 0.707 | | Imaginary part |
| 11 | Cos($5\pi/4$) | -1 | 0.707 | | Real part |
| 12 | Sin($6\,\pi/4$) | -1 | 1 | No $C_{12}r$ | Imaginary part |
| 13 | Cos($6\,\pi/4$) | | 0 | No $C_{13}$ | Real part |
| 14 | Sin($7\,\pi/4$) | -1 | 0.707 | | Imaginary part |
| 15 | Cos($7\,\pi/4$) | +1 | 0.707 | | Real part |

In this table, index lines 1, 4, 9 and 12 indicate the elements needed to implement the circuit with a period of 4 shown in Figure 7. The cells with a y = 0 are not needed, because they would not improve accuracy. In such a case, the linear interpolation of these values is exact.

Since the actual resistance of real resistors and sometimes also the capacitance of capacitors depend on temperature and other influences a calibration for all embodiments of the proposed circuit would be advantageous. This can be done with a replica circuit, having a few filtering stages.

For example, applying an impulse to the input of this short filter would be useful. This can be done by applying a one signal to the center stage's input and a zero signal to the other inputs. After activating the clk_filt the center output's signal will decay from one versus the zero value. In the ideal case this would happen according to:

$$v(t) = C_0 \sqrt{\frac{rc}{\pi t}}$$

When the voltage at the center output reaches a certain level a comparator can deactivate the clk_filt. The result is a reproducible filter impulse response where the pulse width t of the clkfilt signal is controlled to keep rc/t constant.

Claims

1. A method of filtering a signal, comprising the following steps:

   - sampling the signal to obtain a series of signal values SV0 to SVn,
   - storing the signal values SV0 to SVn in form of charges in a series of first capacitors C0 to Cn, the method being **characterized in that** said series of first capacitors C0 to Cn corresponding to said series of signal values SV0 to SVn, and the method further comprises:
   - diffusing the charges on each first capacitor over neighboring capacitors of said series of first capacitors by connecting a resistor for at least partial charge equalization between each pair of consecutive first capacitors Ci, Ci+1 (i=0 to n-1) in said series of first capacitors for a first time interval, said first time interval being selected dependent on a desired filtering result,
   - wherein remaining voltages across the first capacitors of the series of first capacitors after said step of diffusing represent filtered signal values corresponding to a filtered signal.

2. The method according to claim 1,
   **characterized in that**
   said signal values correspond to a time series or positional series of sampled values.

3. The method according to claim 1 or 2, **characterized in that**

   - the signal values SV0 to SVn are stored additionally in form of charges in a series of second capacitors Cb0 to Cbn, said series of second capacitors Cb0 to Cbn corresponding to said series of signal values SV0 to SVn, and
   - the remaining voltages across the first capacitors of the series of first capacitors after said diffusion step are subtracted from the voltages across the second capacitors of the series of second capacitors for each pair of first and corresponding second capacitors Cj, Cbj (j=0 to n) or vice versa, to obtain a difference between the filtered and unfiltered signal.

4. The method according to claim 1 or 2, **characterized in that**

   - the signal values SV0 to SVn are stored additionally in form of charges in a series of second capacitors Cb0 to Cbn, said series of second capacitors Cb0 to Cbn corresponding to said series of signal values SV0 to SVn,
   - diffusing the charges on each second capacitor over neighboring capacitors of said series of second capacitors by connecting a resistor for at least partial charge equalization between each pair of consecutive second capacitors Cbi, Cbi+1 (i=0 to n-1) in said series of second capacitors for a second time interval, said second time interval being selected dependent on a desired second filtering result, and
   - after said steps of diffusing, the remaining voltages across the first capacitors of the series of first capacitors are subtracted from the remaining voltages across the second capacitors of the series of second capacitors for each pair of first and corresponding second capacitors Cj, Cbj (j=0 to n) or vice versa, to obtain a difference between the filtered signals.

5. The method according to claim 4,
   **characterized in that**
   the first and the second time intervals are selected to be equal.

6. The method according to claim 4,
   **characterized in that**
   the second time interval is selected shorter than the first time interval.

7. The method according to one or several of claims 1 to 6, **characterized in that**
   the step of diffusing is repeated one or several times with equal or different first and/or second time intervals before new signal values are stored in the capacitors in order to achieve several filtered signals with different filtering results.

8. The method according to claim 1,
   **characterized in that**
   for performing a Gabor-type filtering based on a Gabor filter comprising a complex exponential function with a real and an imaginary part and an angular frequency $w_{x0}$, the filtering is performed with two of said series of first capacitors C0 to Cn separately for the real and imaginary part, wherein the signal values SV0 to SVn are stored in each case as positive or negative full or partial values, dependent on the position within the period of the angular frequency $w_{x0}$, in the corresponding series of first capacitors C0 to Cn.

9. The method according to claim 8,
**characterized in that**
for a period of the angular frequency $w_{x0}$ corresponding to four consecutive sampling values, the signal values SV0 to SVn are stored alternately as positive and negative values in the corresponding series of first capacitors C0 to Cn, for each of the two series of first capacitors.

10. The method according to claim 8,
**characterized in that**
for a period of the angular frequency $w_{x0}$ corresponding to more than four consecutive sampling values, the storing of the signal values as positive or negative full or partial values is achieved by providing a second capacitor for each capacitor of said series of first capacitors, the second capacitor being connected and a relation of the capacitances of the capacitors of each stage being selected such that the first capacitor is charged with the full or partial signal value corresponding to the position within the period of the angular frequency $w_{x0}$.

11. A filter circuit for filtering a signal, comprising at least one series of capacitors C0 to Cn connected to one or several input lines via sampling switches, such that a signal on at least one of said input line(s) can be sampled using the sampling switches to obtain a series of signal values SV0 to SVn, which are stored in form of charges in the corresponding capacitors C0 to Cn, the filter circuit being **characterized in that**

each capacitor being connected to a different output terminal allowing to tap the voltage across the capacitor at the output terminal,
wherein between each two adjacent capacitors there is a series of a resistor and a switch connected for opening and closing the connection between these capacitors.

**Patentansprüche**

1. Verfahren zum Filtern eines Signals, umfassend die folgenden Schritte:

- Abtasten des Signals, um eine Reihe von Signalwerten SV0 bis SVn zu erlangen,
- Speichern der Signalwerte SV0 bis SVn in Form von Ladungen in einer Reihe von ersten Kondensatoren C0 bis Cn,

wobei das Verfahren **dadurch gekennzeichnet ist, dass** die Reihe von ersten Kondensatoren C0 bis Cn der Reihe von Signalwerten SV0 bis SVn entspricht, und das Verfahren ferner umfasst:

- Verteilen der Ladungen auf jedem ersten Kondensator auf benachbarte Kondensatoren der Reihe von ersten Kondensatoren durch Verbinden eines Widerstands zum zumindest teilweisen Ladungsausgleich zwischen jedem Paar aufeinanderfolgender erster Kondensatoren Ci, Ci+1 (i=0 bis n-1) in der Reihe von ersten Kondensatoren für ein erstes Zeitintervall, wobei das erste Zeitintervall in Abhängigkeit von einem gewünschten Filterergebnis gewählt wird,
- wobei verbleibende Spannungen über den ersten Kondensatoren der Reihe von ersten Kondensatoren nach dem Schritt des Verteilens gefilterte Signalwerte repräsentieren, die einem gefilterten Signal entsprechen.

2. Verfahren nach Anspruch 1,
**dadurch gekennzeichnet, dass**
die Signalwerte einer Zeitreihe oder Positionsreihe abgetasteter Werte entsprechen.

3. Verfahren nach Anspruch 1 oder 2,
**dadurch gekennzeichnet, dass**

- die Signalwerte SV0 bis SVn zusätzlich in Form von Ladungen in einer Reihe von zweiten Kondensatoren Cb0 bis Cbn gespeichert werden, wobei die Reihe von zweiten Kondensatoren Cb0 bis Cbn der Reihe von Signalwerten SV0 bis SVn entspricht, und
- die verbleibenden Spannungen über den ersten Kondensatoren der Reihe von ersten Kondensatoren nach dem Verteilungsschritt von den Spannungen über den zweiten Kondensatoren der Reihe von zweiten Kondensatoren für jedes Paar eines ersten und eines entsprechenden zweiten Kondensators Cj, Cbj (j=0 bis n), oder umgekehrt, subtrahiert werden, um eine Differenz zwischen dem gefilterten und ungefilterten Signal zu erlangen.

4. Verfahren nach Anspruch 1 oder 2,
**dadurch gekennzeichnet, dass**

- die Signalwerte SV0 bis SVn zusätzlich in Form von Ladungen in einer Reihe von zweiten Kondensatoren Cb0 bis Cbn gespeichert werden, wobei die Reihe von zweiten Kondensatoren Cb0 bis Cbn der Reihe von Signalwerten SV0 bis SVn entspricht,
- Verteilen der Ladungen auf jedem zweiten Kondensator auf benachbarte Kondensatoren der Reihe von zweiten Kondensatoren durch Verbinden eines Widerstands zum zumindest teilweisen Ladungsausgleich zwischen jedem Paar aufeinanderfolgender zweiter Kondensatoren Cbi, Cbi+1 (i=0 bis n-1) in der Reihe von zweiten Kondensatoren für ein zweites Zeitintervall, wobei das zweite Zeitintervall in Abhängigkeit von einem gewünschten zweiten Filterergebnis gewählt wird, und
- nach den Schritten des Verteilens, die verbleibenden Spannungen über den ersten Kondensatoren der Reihe von ersten Kondensatoren von den verbleibenden Spannungen über den zweiten Kondensatoren der Reihe von zweiten Kondensatoren für jedes Paar eines ersten und eines entsprechenden zweiten Kondensators Cj, Cbj (j=0 bis n), oder umgekehrt, subtrahiert werden, um eine Differenz zwischen den gefilterten Signalen zu erlangen.

5. Verfahren nach Anspruch 4,
**dadurch gekennzeichnet, dass**
das erste und das zweite Zeitintervall derart gewählt werden, dass sie gleich sind.

6. Verfahren nach Anspruch 4,
**dadurch gekennzeichnet, dass**
das zweite Zeitintervall kürzer als das erste Zeitintervall gewählt wird.

7. Verfahren nach einem oder mehreren der Ansprüche 1 bis 6, **dadurch gekennzeichnet, dass**
der Schritt des Verteilens einmal oder mehrmals mit gleichen oder unterschiedlichen ersten und/oder zweiten Zeitintervallen wiederholt wird, bevor neue Signalwerte in den Kondensatoren gespeichert werden, um mehrere gefilterte Signale mit unterschiedlichen Filterungsergebnissen zu erzielen.

8. Verfahren nach Anspruch 1,
**dadurch gekennzeichnet, dass**
zum Durchführen eines Filterns des Gabor-Typs basierend auf einem Gabor-Filter, der eine komplexe Exponentialfunktion mit einem Real- und einem Imaginärteil und einer Kreisfrequenz $w_{x0}$ umfasst, das Filtern mit zwei der Reihen von ersten Kondensatoren C0 bis Cn getrennt für den Real- und den Imaginärteil durchgeführt wird, wobei die Signalwerte SV0 bis SVn jeweils als positive oder negative Voll- oder Teilwerte, abhängig von der Position innerhalb der Periode der Kreisfrequenz $w_{x0}$, in der entsprechenden Reihe von ersten Kondensatoren C0 bis Cn gespeichert werden.

9. Verfahren nach Anspruch 8,
**dadurch gekennzeichnet, dass**
für eine Periode der Kreisfrequenz $w_{x0}$, die vier aufeinanderfolgenden Abtastwerten entspricht, die Signalwerte SV0 bis SVn abwechselnd als positive und negative Werte in der entsprechenden Reihe von ersten Kondensatoren C0 bis Cn für jede der zwei Reihen von ersten Kondensatoren gespeichert werden.

10. Verfahren nach Anspruch 8,
**dadurch gekennzeichnet, dass**
für eine Periode der Kreisfrequenz $w_{x0}$, die mehr als vier aufeinanderfolgenden Abtastwerten entspricht, das Speichern der Signalwerte als positive oder negative Voll- oder Teilwerte erzielt wird, indem ein zweiter Kondensator für jeden Kondensator der Reihe von ersten Kondensatoren bereitgestellt wird, wobei der zweite Kondensator verbunden und ein Verhältnis der Kapazitäten der Kondensatoren jeder Stufe derart gewählt wird, dass der erste Kondensator mit dem Voll- oder Teilsignalwert geladen wird, der der Position innerhalb der Periode der Kreisfrequenz $w_{x0}$ entspricht.

11. Filterschaltung zum Filtern eines Signals,

die mindestens eine Reihe von Kondensatoren C0 bis Cn aufweist, die über Abtastschalter mit einer oder mehreren Eingangsleitungen verbunden sind, so dass ein Signal auf mindestens einer der Eingangsleitung(en) unter Verwendung der Abtastschalter abgetastet werden kann, um eine Reihe von Signalwerten SV0 bis SVn zu erlangen, die in Form von Ladungen in den entsprechenden Kondensatoren C0 bis Cn gespeichert werden, wobei die Filterschaltung **dadurch gekennzeichnet ist, dass**

jeder Kondensator mit einem anderen Ausgangsanschluss verbunden ist, was ein Abgreifen der Spannung über dem Kondensator am Ausgangsanschluss ermöglicht, wobei jeweils zwischen zwei benachbarten Kondensatoren eine Reihe eines Widerstands und eines Schalters zum Öffnen und Schließen der Verbindung zwischen diesen Kondensatoren verbunden ist.

**Revendications**

1. Procédé de filtrage d'un signal, comprenant les étapes suivantes :

   - l'échantillonnage du signal pour obtenir une série de valeurs de signal SV0 à SVn,
   - le stockage des valeurs de signal SV0 à SVn sous forme de charges dans une série de premiers condensateurs C0 à Cn,

   le procédé étant **caractérisé en ce que** ladite série de premiers condensateurs C0 à Cn correspond à ladite série de valeurs de signal SV0 à SVn et le procédé comprend en outre :

   - la diffusion des charges sur chaque premier condensateur sur les condensateurs voisins de ladite série de premiers condensateurs en connectant une résistance pour une égalisation de charge au moins partielle entre chaque paire de premiers condensateurs consécutifs $C_i$, $C_{i+1}$ (i=0 à n-1) dans ladite série de premiers condensateurs pendant un premier intervalle de temps, ledit premier intervalle de temps étant sélectionné en fonction d'un résultat de filtrage souhaité,
   - dans lequel les tensions restantes aux bornes des premiers condensateurs de la série de premiers condensateurs après ladite étape de diffusion de diffusion représentent les valeurs de signal filtrées correspondant à un signal filtré.

2. Procédé selon la revendication 1, **caractérisé en ce que** lesdites valeurs de signal correspondent à une série temporelle ou une série positionnelle de valeurs échantillonnées.

3. Procédé selon la revendication 1 ou 2, **caractérisé en ce que** :

   - les valeurs des signaux SV0 à SVn sont stockées sous forme de charges dans une série de deuxièmes condensateurs Cb0 à Cbn, ladite série de deuxièmes condensateurs Cb0 à Cbn correspondant à ladite série de valeurs de signaux SV0 à SVn et
   - les tensions restantes aux bornes des premiers condensateurs de la série de premiers condensateurs après ladite étape de diffusion sont soustraites des tensions aux bornes des deuxièmes condensateurs de la série de deuxièmes condensateurs pour chaque paire de premiers et deuxièmes condensateurs correspondants $C_j$, $C_{bj}$ (j=0 à n) ou inversement, afin d'obtenir une différence entre le signal filtré et le signal non filtré.

4. Procédé selon la revendication 1 ou 2, **caractérisé en ce que** :

   - les valeurs des signaux SV0 à SVn sont stockées additionnellement sous forme de charges dans une série de deuxièmes condensateurs Cb0 à Cbn, ladite série de deuxièmes condensateurs Cb0 à Cbn correspondant aux valeurs des signaux SV0 à SVn ;
   - les charges de chaque deuxième condensateur sont diffusées sur les condensateurs voisins de ladite série en connectant une résistance assurant une égalisation de charge, au moins partielle, entre chaque paire de deuxièmes condensateurs consécutifs $C_{bi}$, $C_{bi+l}$ (i=0 à n-1) dans ladite série de deuxièmes condensateurs pendant un deuxième intervalle de temps, ledit deuxième intervalle de temps étant choisi en fonction d'un deuxième résultat de filtrage souhaité ; et
   - après lesdites étapes de diffusion, les tensions restantes aux bornes des premiers condensateurs de la série de premiers condensateurs sont soustraites des tensions restantes aux bornes des deuxièmes condensateurs de la série de deuxièmes condensateurs pour chaque paire de premiers et deuxièmes condensateurs correspondants $C_j$, $C_{bj}$ (j=0 à n) ou inversement, afin d'obtenir une différence entre les signaux filtrés.

**5.** Procédé selon la revendication 4, **caractérisé en ce que** les premier et deuxième intervalles de temps sont choisis comme étant égaux.

**6.** Procédé selon la revendication 4, **caractérisé en ce que** le deuxième intervalle de temps est choisi comme étant plus court que le premier intervalle de temps.

**7.** Procédé selon une ou plusieurs des revendications 1 à 6, **caractérisé en ce que** l'étape de diffusion est répétée une ou plusieurs fois avec des premier et/ou deuxième intervalles de temps égaux ou différents avant que de nouvelles valeurs de signal ne soient stockées dans les condensateurs afin d'obtenir plusieurs signaux filtrés avec des résultats de filtrage différents.

**8.** Procédé selon la revendication 1, **caractérisé en ce que** pour effectuer un filtrage de type Gabor basé sur un filtre de Gabor comprenant une fonction exponentielle complexe avec une partie réelle et une partie imaginaire et une fréquence angulaire $W_{x0}$, le filtrage est effectué avec deux desdites séries de premiers condensateurs C0 à Cn, séparément pour la partie réelle et la partie imaginaire, dans lequel les valeurs du signal SV0 à SVn sont stockées dans chaque cas sous forme de valeurs entières ou partielles positives ou négatives, en fonction de la position dans la période de la fréquence angulaire $W_{x0}$ dans la série correspondante de premiers condensateurs C0 à Cn.

**9.** Procédé selon la revendication 8, **caractérisé en ce que** pour une période de la fréquence angulaire $W_{x0}$ correspondant à quatre valeurs d'échantillonnage consécutives, les valeurs du signal SV0 à SVn sont stockées alternativement sous forme de valeurs positives et négatives dans les séries correspondantes de premiers condensateurs C0 à Cn, pour chacune des deux séries de premiers condensateurs.

**10.** Procédé selon la revendication 8, **caractérisé en ce que** pour une période de la fréquence angulaire $w_{x0}$ correspondant à plus de quatre valeurs d'échantillonnage consécutives, le stockage des valeurs du signal sous forme de valeurs entières ou partielles positives ou négatives est réalisé en prévoyant un deuxième condensateur pour chaque condensateur de ladite série de premiers condensateurs, le deuxième condensateur étant connecté et une relation entre les capacités des condensateurs de chaque étage est sélectionnée de telle sorte que le premier condensateur soit chargé avec la valeur totale ou partielle du signal correspondant à la position dans la période de la fréquence angulaire $w_{x0}$.

**11.** Circuit de filtrage pour filtrer un signal, comprenant au moins une série de condensateurs C0 à Cn connectés à une ou plusieurs lignes d'entrée via des commutateurs d'échantillonnage, de sorte qu'un signal sur au moins une desdites lignes d'entrée puisse être échantillonné à l'aide des commutateurs d'échantillonnage pour obtenir une série de valeurs de signal SV0 à SVn, qui sont stockées sous forme de charges dans les condensateurs correspondants C0 à Cn, le circuit de filtrage étant **caractérisé en ce que** chaque condensateur est connecté à une borne de sortie différente permettant de prélever la tension aux bornes du condensateur à la borne de sortie, dans lequel entre chaque paire de condensateurs adjacents se trouve une série d'une résistance et d'un commutateur connectés pour ouvrir et fermer la connexion entre ces condensateurs.

<u>Fig. 1</u>

Fig. 2

Fig. 3

Fig. 4

Fig. 5

Fig. 6

Fig. 7

Fig. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2012014464 A1
- WO 2012129296 A1
- EP 1246121 B1

**Non-patent literature cited in the description**

- **B.E. SHI**. Gabor-type filtering in space and time with cellular neural networks. *IEEE Transactions on Circuits and Systems I: Fundamental Theory and Application*, 1998, vol. 45 (2), 121-132
- **LIEBERSTEIN, H. MELVIN**. Mathematics in Science and Engineering: Theory of Partial Differential Equations. Elsevier, 1972